Europäisches Patentamt

European Patent Office

Office européen des brevets

(11) Veröffentlichungsnummer: **0 277 569 B1**

# (12) EUROPÄISCHE PATENTSCHRIFT

(45) Veröffentlichungstag der Patentschrift: **12.06.91**

(51) Int. Cl.5: **H02B 1/28**, H05K 5/06

(21) Anmeldenummer: **88100997.1**

(22) Anmeldetag: **23.01.88**

(54) **Türflügel für Gehäuse und Schränke zum Einbau elektrischer Geräte und Verfahren zu seiner Herstellung.**

(30) Priorität: **03.02.87 DE 3703090**

(43) Veröffentlichungstag der Anmeldung:
**10.08.88 Patentblatt 88/32**

(45) Bekanntmachung des Hinweises auf die
Patenterteilung:
**12.06.91 Patentblatt 91/24**

(84) Benannte Vertragsstaaten:
**AT BE CH DE ES FR GB GR IT LI LU NL SE**

(56) Entgegenhaltungen:
**DE-A- 2 604 126**
**DE-U- 1 877 058**

(73) Patentinhaber: **Schroff GmbH**
**Industriegebiet**
**W-7541 Straubenhardt 1(DE)**

(72) Erfinder: **Schwenk, Hans Martin**
**Wiesenweg 9**
**W-7541 Straubenhardt 2(DE)**
Erfinder: **Stohr, Lucien**
**Rue la foret**
**F-67660 Betschdorf(FR)**
Erfinder: **Ratzel, Siegfried**
**Veilchenstrasse 9**
**W-7519 Gondelsheim(DE)**

(74) Vertreter: **Durm, Klaus, Dr.-Ing. et al**
**Patentanwälte Dr.-Ing. Klaus Durm Dipl.-Ing.**
**Frank Durm Felix-Mottl-Strasse 1a**
**W-7500 Karlsruhe 21(DE)**

## Beschreibung

Die Erfindung betrifft einen Türflügel für Gehäuse und Schränke zum Einbau elektrischer Geräte gemäß dem Oberbegriff des Patentanspruchs 1.

Die Erfindung betrifft ferner ein Verfahren zur Herstellung eines Türflügels für Gehäuse und Schränke zum Einbau elektrischer Geräte gemäß Patentanspruch 9.

Mit einem derartigen Türflügel versehene Gehäuse und Schränke finden in der Industrieelektronik Anwendung. Die einzelnen elektrischen und elektronischen Bauteile sind auf Montageplatten, Baugruppenträger oder gegebenenfalls Schwenkrahmen montiert, welche in das Gehäuseinnere eingebaut sind. Nach Öffnen des Türflügels sind die eingebauten elektrischen Geräte frei zugänglich. Um auch bei geschlossener Tür zumindest eine optische Kontrolle des eingebauten Gerätes zu ermöglichen oder angezeigte Meß-und Betriebsparameter ablesen zu können, ist ein Teil des Türflügels verglast. Die zwischen dem Türflügel-Rahmen und dem Rand der eingesetzten durchsichtigen Scheibe vorgesehene Dichtungsleiste dient sowohl der zuverlässigen Halterung der Scheibe als auch der Abdichtung gegen das Eindringen von Schmutz und Feuchtigkeit. An derartige verglaste Türflügel, insbesondere für größere Schränke, werden sehr hohe Anforderungen hinsichtlich Stabilität und Dichtigkeit gestellt, weshalb diese in Konstruktion und Herstellungsverfahren üblicherweise aufwendig sind.

Es sind Gehäuse und Schränke für die Industrieelektronik bekannt, in deren Türflügel eine Scheibe unter Zwischenlegen einer ebenen Dichtung von hinten auf den Türrahmen aufgeschraubt ist. Es ist ferner bekannt, die Scheibe mittels Klemmhebel oder federnder Clips gegen den Rahmen zu pressen. Derartige, in Abständen rings um den Rand der Scheibe vorgesehene Befestigungsmittel pressen die Scheibe nur punktuell auf den Rahmen; örtliche Überbeanspruchungen der zwischengelegten Dichtungsleiste führen zu starken Verspannungen in der empfindlichen Scheibe und zu Dichtungsproblemen. Die Montage der Scheibe erfordert eine Vielzahl von einzelnen Handgriffen.

Es ist ferner bekannt, eine Glasscheibe mit einem elastischen Kunststoff zu umspritzen, um das so erhaltene Verbundteil aus Scheibe und Dichtungsleiste anschließend in einen Rahmen einzukleben. Das Anspritzen einer Dichtungsleiste direkt an die Scheibe und die spätere Klebung sind aufwendige Arbeitsprozesse, welche nur von speziell ausgebildetem Personal und unter Einsatz von teuren Maschinen vorgenommen werden können.

Schließlich ist es bekannt (DE-A-2 604 126), eine Scheibe in eine vorbereitete Öffnung durch Einziehen einer entsprechend ausgebildeten, vorgefertigten Dichtungsleiste einzusetzen. Diese Art der Montage einer Scheibe erfordert jedoch großes Geschick; außerdem wird sowohl die Scheibe als auch die Dichtungsleiste mechanisch stark beansprucht.

Aufgabe der vorliegenden Erfindung ist es, einen verglasten Türflügel für Gehäuse und Schränke zum Einbau elektrischer Geräte zu schaffen, bei dem die eingesetzte Scheibe fest in dem sie umgebenden Rahmen eingebettet ist, der sich durch eine besonders gute Dichtigkeit zwischen Scheibe und Rahmen auszeichnet, und der möglichst einfach und kostengünstig herstellbar ist.

Es soll ferner ein einfach auszuführendes und billiges Verfahren zur Herstellung eines derartigen Türflügels angegeben werden.

Bei der Lösung dieser technischen Aufgabe wird ausgegangen von einem Türflügel der eingangs erwähnten Art; gelöst wird die Aufgabe durch die Merkmale des kenzeichenden Teils des Patentanspruchs 1.

Bei der Lösung der verfahrensmäßigen Aufgabe wird ausgegangen von einem Herstellungsverfahren für einen Türflügel, wie oben angegeben; gelöst wird die Aufgabe durch die Merkmale des kenzeichenden Teils des Patentanspruchs 9.

Der erfindungsgemäße Türflügel besteht im wesentlichen nur aus zwei Teilen: dem vorgefertigten Rahmen, um dessen Öffnung die speziell ausgebildete Winkelleiste angeordnet ist, sowie der in ihre Maßen abgestimmten durchsichtigen Scheibe. Die Scheibe wird einfach von hinten in den Rahmen eingelegt und anschließend durch Einbringen der teigigen oder dickflüssigen Kunststoff-Masse in den Bereich zwischen Winkelleiste, Rahmen und Scheibe befestigt. Nach dem Erstarren der Kunststoff-Masse hält die so gebildete Dichtungsleiste die Scheibe zuverlässig und elastisch in ihrer vorgesehenen Lage fest. Die Dichtungsleiste stützt sich ihrerseits nach außen gegen den einen Schenkel der Winkelleiste und senkrecht zum Rahmen gegen deren freien Schenkel ab. Der Rand der Scheibe wird im Bereich der Winkelleiste völlig gleichmäßig auf den Rahmen gedrückt, was eine hervorragende Abdichtung der Öffnung ergibt. Die Herstellung des mit der Erfindung geschaffenen Türflügels ist mittels weniger aufeinander folgender Verfahrensschritte schnell und leicht möglich.

Bevorzugt wird eine Ausführung, bei der der lichte Abstand zwischen den gegeneinanderweisenden freien Schenkeln, entlang gegenüberliegender Kanten der Scheibe verlaufender Abschnitte der Winkelleiste geringfügig größer ist als das entsprechende Maß der Scheibe. Die Scheibe läßt sich dann leicht von oben zwischen die Winkelleisten einlegen.

In zweckmäßiger Ausgestaltung der Erfindung steht der eine Schenkel der Winkelleiste mit seiner Längskante senkrecht auf dem Rahmen auf. Der andere, zur Öffnung hin weisende freie Schenkel der Winkelleiste verläuft parallel zur Scheibe. Dergestalt ausgebildete Winkelleisten bilden ein gutes Widerlager für die zur Dichtungsleiste erstarrte Kunststoff-Masse.

Zur schnellen Einführung einer genügenden Menge von teigiger oder dickflüssiger Kunststoff-Masse ist es von Vorteil, wenn der Abstand, in dem der freie Schenkel über den Rahmen verläuft, wenigstens doppelt so groß ist, wie die Dicke der Scheibe. Eine vollständige Ausfüllung des Raumes zwischen Winkelleiste, Rahmen und Scheibenrand ist gewährleistet, wenn der eine Schenkel der Winkelleiste bogenförmig in deren anderen freien Schenkel übergeht. Die sich dabei ergebende rundliche Form der Dichtungsleiste führt zu einer besonders guten Ausfüllung des Raums zwischen Scheibenrand und Winkelleiste. Als zweckmäßig hat es sich ferner erwiesen, wenn die dem mit Kunststoff-Masse ausgefüllten Raum zugewandte Innenkante zwischen dem einen Schenkel der Winkelleiste und dem Rahmen abgerundet ist.

Zur Abdichtung des kompletten Türflügels gegenüber dem Körper des Gehäuses oder Schrankes dient üblicherweise eine entlang des äußeren Rahmenrandes ringsum laufende elastische Türdichtung, die gegen eine am Gehäusekörper vorgesehene Messerkante abdichtet. In vorteilhafter Weiterbildung der Erfindung ist diese Türdichtung einstückig an die Dichtungsleiste angeformt. Dichtungsleiste zwischen Scheibe und Rahmen und Türdichtung zwischen Türflügel und Gehäusekörper sind somit integriert und können in einem einzigen gemeinsamen Verfahrensschritt hergestellt werden.

Bei einer weiteren Ausführung des erfindungsgemäßen Türflügels ist die Scheibe in einem geringen Abstand zum Rahmen angeordnet und ist der so entstandene Spalt zwischen Scheibe und Rahmen ebenfalls mit Kunststoff-Masse ausgefüllt. Eine unmittelbare Berührung der empfindlichen Scheibe mit dem Rahmen wird hierdurch ausgeschlossen; der Rand der Scheibe ist vollständig in die elastische Kunststoff-Masse bzw. Dichtungsleiste eingebettet. Um die Scheibe im Abstand zum Rahmen zu halten, können besondere Distanzelemente zwischen Scheibe und Rahmen eingelegt sein, welche seitlich von der Kunststoff-Masse umgeben sind.

Bevorzugt wird zu Bildung der Dichtungsleiste eine Kunststoff-Masse verwendet, welche aufgeschäumt ist. Als besonders geeignet hat sich Polyurethan-Schaum erwiesen. Es kann statt dessen aber auch Silikon-Kautschuk verwendet werden.

In vorteilhafter Weiterbildung des erfindungsgemäßen Verfahrens zur Herstellung des Türflügels wird die Kunststoff-Masse unter mäßigem Druck in den Raum eingebracht. Unter Druckeinwirkung paßt sich die Kunststoff-Masse vollständig der Form des Raumes zwischen Winkelleiste, Rahmen und Scheibenrand an, sodaß keine Hohlräume verbleiben und die Scheibe vollständig elastisch eingebettet ist.

Wird die Scheibe während des Einbringens der Kunststoff-Masse in einem geringen Abstand vom Rahmen gehalten, so gelangt ein Teil der teigigen oder dickflüssigen Masse in den Spalt zwischen Rahmen und Scheibe. Nach dem Erstarren der Kunststoff-Masse ist die Scheibe an ihrem Rand beidseitig in die elastische Dichtungsleiste eingebettet. Das Halten der Scheibe in einem geringen Abstand vom Rahmen während des Einbringens der Kunststoff-Masse kann vorteilhafterweise durch Einlegen von Distanzelementen in den Rahmen vor dem Einsetzen der Scheibe bewirkt werden.

In vorteilhafter Weiterbildung des erfindungsgemäßen Herstellungsverfahrens wird unmittelbar nach dem Einbringen der Kunststoff-Masse zwischen die Winkelleiste und die Scheibe eine Türdichtung einstückig an die Dichtungsleiste angeformt. Die Türdichtung ist damit in die Dichtungsleiste integriert.

Besonders gut läßt sich eine aufgeschäumte Kunststoff-Masse, beispielsweise Polyurethan-Schaum verwenden. Das vorgeschlagene Herstellungsverfahren läßt sich aber auch mit Silikon-Kautschuk als Material für die Dichtungsleiste durchführen.

Ausführungsbeispiele der Erfindung werden nachstehend anhand der beigefügten Zeichnungen näher erläutert.
Es zeigen:

Fig. 1    die Rückseite eines Türflügels, in einer Draufsicht;

Fig. 2    einen Teil des Türflügels von Fig. 1 in einem Vertikalschnitt entlang der Linie A-A, in gegenüber Fig. 1 vergößertem Maßstab;

Fig. 3    eine zweite Ausführungsform eines Türflügels, mit an die Dichtungsleiste einstückig angeformter Türdichtung, in einem Vertikalschnitt;

Fig. 4    eine weitere Ausführung eines Türflügels, mit Distanzelementen zwischen Scheibe und Rahmen, ebenfalls in einem Vertikalschnitt.

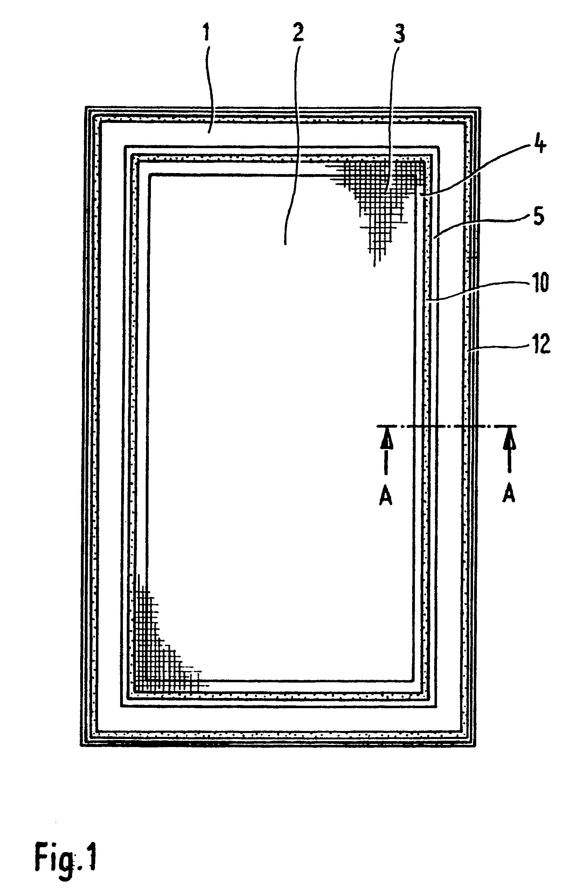

Der in Figur 1 dargestellte Türflügel für einen Schrank zum Einbau elektrischer Geräte besteht im wesentlichen aus einem Rahmen 1, der eine Öffnung 2 umschließt, und einer durchsichtigen Scheibe 3, welche in den Rahmen 1 eingesetzt ist und die Öffnung 2 abdeckt. An dem Rahmen 1 ist eine rings um den Rand 4 der Scheibe 3 umlaufende Winkelleiste 5 angeordnet.

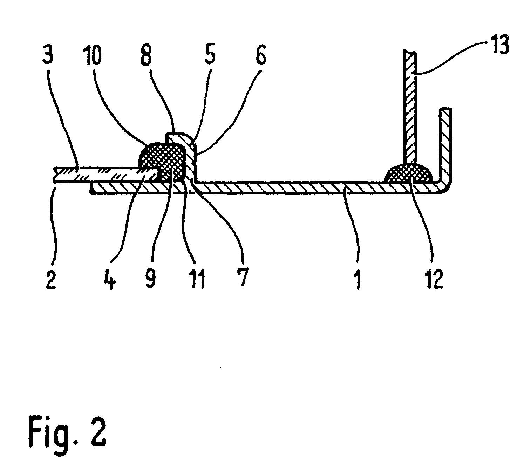

Wie aus Figur 2 hervorgeht, ist die Winkelleiste 5 zusammengesetzt aus einem Schenkel 6, welcher mit seiner Längskante 7 auf dem Rahmen 1 senkrecht aufsteht und mit diesem verbunden ist, und einem freien Schenkel 8, welcher vom Schenkel 6 rechtwinklig absteht und in Richtung zur Öffnung 2 weist. Der Schenkel 6 geht bogenförmig in den freien Schenkel 8 über. Der Abstand, in dem der freie Schenkel 8 parallel über dem Rahmen 1 verläuft, ist ungefähr doppelt so groß wie die Dicke der Scheibe 3. Rahmen 1, Rand 4 der Scheibe 3 und Winkelleiste 5 umgrenzen einen zur Öffnung 2 hin offenen Raum, der mit einer in teigigem oder flüssigem Zustand eingebrachten, erstarrten elastischen Kunststoff-Masse vollständig ausgefüllt ist, welche eine Dichtungsleiste 10 bildet. Die dem Raum 9 zugewandte Innenkante 11 zwischen dem einen Schenkel 6 der Winkelleiste 5 und dem Rahmen 1 ist abgerundet. Die Scheibe 3 wird von der Dichtungsleiste 10, welche sich gegen die Winkelleiste 5 abstützt, in ihrer vorgesehenen Lage festgehalten und auf den Rahmen 1 gedrückt.

Der lichte Abstand zwischen den gegeneinanderweisenden freien Schenkeln 6 entlang gegenüberliegender Kanten der Scheibe 3 verlaufender Abschnitte der ringsumlaufenden Winkelleiste 5 - vgl. Figur 1 - ist geringfügig größer als die entsprechende Breite bzw. Länge der Scheibe 3. Zur Montage läßt sich die Scheibe 3 deshalb einfach von oben in den Rahmen 1 einlegen. Die formschlüssige Verbindung zwischen Scheibe 3 und Rahmen 1 geschieht anschließend durch Einbringen von dickflüssiger oder teigiger Kunststoff-Masse, beispielsweise Polyurethan-Schaum, zwischen Winkelleiste 5 und Rand der Scheibe 3. Nach Erstarren der Kunststoff-Masse zur Dichtungsleiste 10 kann der fertige Türflügel an den (nicht dargestellten) Körper des Schranks zum Einbau eines elektrischen Geräts anmontiert werden. Der Abdichtung des geschlossenen Schranks dient eine Türdichtung 12, die außen am Rahmen 1 des Türflügels umläuft (vgl. Figur 1). Die Türdichtung 12 dichtet gegen eine am Gehäusekörper vorgesehene Messerkante 13 (vgl. Figur 2) ab.

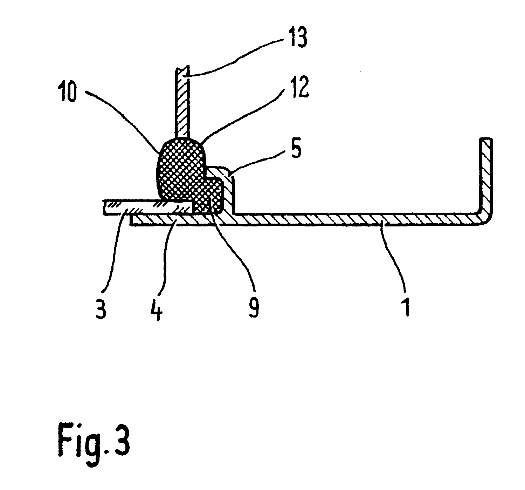

Figur 3 zeigt eine Ausführung eines Türflügels, bei dem derselbe, aus Stahlblech gefertigte Rahmen 1 wie bei den in den Figuren 1 und 2 dargestellten Türflügeln Verwendung findet, bei dem die Türdichtung 12 jedoch einstückig an die Dichtungsleiste 10 angeformt ist.

Türdichtung 12 und Dichtungsleiste 10 lassen sich so in einem einzigen Arbeitsgang herstellen, wobei die Anformung der Türdichtung 12 unmittelbar in Anschluß an die vollständige Ausfüllung des Raumes 9 mit Kunststoff-Masse erfolgt.

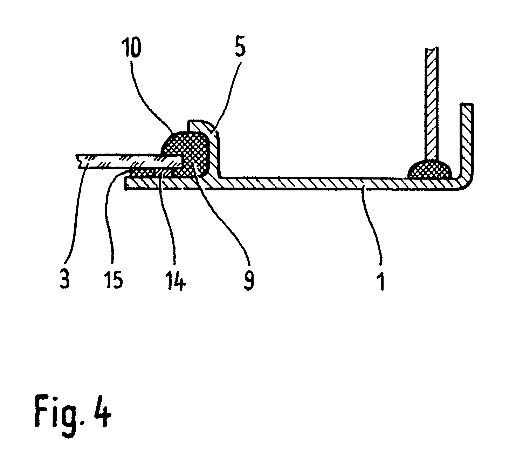

Bei dem in Figur 4 dargestellten Türflügel sind zusätzlich Distanzelemente 14 zwischen dem Rand 4 der Scheibe 3 und dem Rahmen 1 vorgesehen. Diese Distanzelemente 14 werden vor dem Einsetzen der Scheibe 3 in den Rahmen 1 eingelegt; sie halten die Scheibe 3 in einem geringen Abstand vom Rahmen 1. Ein Teil der in teigigem oder flüssigem Zustand eingebrachten Kunststoff-Masse gelangt so in den Spalt 15 zwischen Scheibe 3 und Rahmen 1 und füllt diesen aus. Nach dem Erstarren der Kunststoff-Masse ist der Rand 4 der Scheibe 3 allseitig in die elastische Dichtungsleiste 10 eingebettet.

Der Rahmen 1 des Türflügels besteht aus Stahlblech. Die aufgesetzte Winkelleiste 5 ist aus Strangpress-Profilen zusammengesetzt, welche auf den Rahmen 1 aufgeschweißt sind. Die Scheibe 3 ist aus gewöhnlichem Fensterglas, es kann aber auch eine Sicherheitsglas-Scheibe eingesetzt werden.

**Ansprüche**

1.  Türflügel für Gehäuse und Schränke zum Einbau elektrischer Geräte, mit
    - einem Rahmen (1), der eine Öffnung (2) umschließt;
    - einer durchsichtigen Scheiben (3), die in den Rahmen (1) eingesetzt ist und die Öffnung (2) abdeckt;
    - einer parallel und im Abstand zu den Kanten der Scheibe (3) umlaufende Winkelleiste (5), die mit der Längskante (7) ihres einen Schenkels (6) auf dem Rahmen (1) aufsteht und mit diesem verbunden ist, und deren anderer freier Schenkel (8) zur Öffnung (2) hin weist;
    - einem von der Winkelleiste (5), dem Rahmen (1) und dem Rand (4) der Scheibe (3) umgrenzten Raum (9), der zur Öffnung (2) hin offen ist;
    - einer diesen Raum (9) ausfüllenden, elastischen Dichtungsleiste (10), die den Rand (4) der Scheibe (3) festhält und gegenüber dem Rahmen (1) und der Winkelleiste (5) abdichtet;
    dadurch **gekennzeichnet**, daß
    - der lichte Abstand zwischen den gegeneinanderweisenden, freien Schenkeln (8) zumindest zweier, entlang gegenüberliegender Kanten der Scheibe (3) verlaufender Abschnitte der Winkelleiste (5) geringfügig größer ist als das entsprechende Maß der Scheibe (3);
    - die Dichtungsleiste (10) von einer in teigigem oder flüssigem Zustand eingebrachten, erstarrten elastischen Kunststoff-Masse gebildet wird, welche den Raum (9) zwischen Winkelleiste (5), Rahmen (1) und Rand (4) der Scheibe (3) ausfüllt und die Scheibe (3) entlang ihres Randes (4) gleichmäßig auf den Rahmen (1) drückt.

2. Türflügel nach Anspruch 1, dadurch **gekennzeichnet**, daß der Abstand, in dem der freie Schenkel (8) über dem Rahmen (1) verläuft, wenigstens doppelt so groß ist wie die Dicke der Scheibe (3).

3. Türflügel nach Anspruch 1 oder 2, dadurch **gekennzeichnet**, daß der eine Schenkel (6) bogenförmig in den anderen freien Schenkel (8) übergeht.

4. Türflügel nach einem der Ansprüche 1 bis 3, dadurch **gekennzeichnet**, daß die dem mit Kunststoff-Masse ausgefüllten Raum (9) zugewandte Innenkante (11) zwischen dem einen Schenkel (6) der Winkelleiste (5) und dem Rahmen (1) abgerundet ist.

5. Türflügel nach einem der Ansprüche 1 bis 4, dadurch **gekennzeichnet**, daß an die Dichtungsleiste (10) eine Türdichtung (12) einstückig angeformt ist.

6. Türflügel nach einem der Ansprüche 1 bis 5, dadurch **gekennzeichnet**, daß die Scheibe (3) eben auf dem Rahmen (1) aufliegt.

7. Türflügel nach einem der Ansprüche 1 bis 6, dadurch **gekennzeichnet**, daß die Scheibe (3) in einem geringen Abstand zum Rahmen (1) angeordnet ist und die Kunststoff-Masse den Spalt (15) zwischen Scheibe (3) und Rahmen (1) ausfüllt.

8. Türflügel nach Anspruch 1 dadurch **gekennzeichnet**, daß zwischen Scheibe (3) und Rahmen (1) Distanzelemente (14) eingelegt sind, die seitlich von der Kunststoff-Masse umgeben sind.

9. Verfahren zur Herstellung eines Türflügels für Gehäuse und Schränke zum Einbau elektrischer Geräte gemäß Anspruch 1, **gekennzeichnet** durch die aufeinanderfolgenden Verfahrensschritte:
   - Vorfertigung des Rahmens (1);
   - Einlegen der Scheibe (3) in den Rahmen (1) von der Seite der Winkelleiste (5) her;
   - Einbringen der Kunststoff-Masse in teigigem oder dickflüssigem Zustand in den Raum (9) zwischen Winkelleiste (5), Rahmen (1) und Rand (4) der Scheibe (3);

   - Erstarrenlassen der eingebrachten Kunststoff-Masse zu der elastischen Dichtungsleiste (10).

10. Verfahren nach Anspruch 9, dadurch **gekennzeichnet**, daß die Kunststoff-Masse unter mäßigem Druck in den Raum (9) eingebracht wird.

11. Verfahren nach Anspruch 9 oder 10, dadurch **gekennzeichnet**, daß die Scheibe (3) während des Einbringens der Kunststoff-Masse in einem geringen Abstand vom Rahmen (1) gehalten wird, so daß ein Teil der Kunststoff-Masse über den Raum (9) in den Spalt (15) zwischen Rahmen und Scheibe gelangt.

**Claims**

1. Door leaf for housings and cabinets for the installation of electrical equipment, with
   - a frame (1) which surrounds an opening (2);
   - a transparent pane (3) which is inserted into the frame (1) and covers the opening (2);
   - an angle strip (5) surrounding the edges of the pane (3) parallel there to and spaced therefrom, which strip projects with the longitudinal edge (7) of one leg (6) thereof on the frame (1) and is connected therewith, and the other free leg (8) of which points towards the opening (2);
   - a space (9) open towards the opening (2) and defined by the angle strip (5), the frame (1) and the edge (a) of the pane (3);
   - an elastic sealing strip (10) filling out this space (9), which strip holds the edge (4) of the pane (3) fast and seals it from the frame (1) and the angle strip (5);
   characterised in that
   - the clear gap between the mutually facing free legs (8) of at least two sections of the angle strip (5), which extend along opposite edges of the pane (3), is slightly greater than the corresponding dimension of the pane (3);
   - the sealing strip (10) is formed by a solidified elastic synthetic plastics composition introduced in a pasty or liquid condition, which fills out the space (9) between angle strip (5), frame (1) and edge (4) of the pane (3) and presses the pane (3) uniformly upon the frame (1) along the edge (a) of the pane.

2. Door leaf according to claim 1, characterised in that the distance in which the free leg (8) extends over the frame (1) is at least twice as great as the thickness of the pane (3).

3. Door leaf according to claim 1 or 2, characterised in that the one leg (6) merges arcuately into the other free leg (8).

4. Door leaf according to one of claims 1 to 3, characterised in that the inner edge (11) facing the space (9) filled out with synthetic plastics composition is rounded off between the one leg (6) of the angle strip (5) and the frame (1).

5. Door leaf according to one of claims 1 to 4, characterised in that a door seal (12) is integrally formed on the sealing strip (10).

6. Door leaf according to one of claims 1 to 5, characterised in that the pane (3) lies flat on the frame (1).

7. Door leaf according to one of claims 1 to 6, characterised in that the pane (3) is arranged at a short distance from the frame (1) and the synthetic plastics composition fills out the gap (15) between pane (3) and frame (1).

8. Door leaf according to claim 7, characterised in that spacer elements (14) laterally surrounded by the synthetic plastics composition are inserted between pane (3) and frame (1).

9. Method for the production of a door leaf for housings and cabinets for the installation of electrical equipment according to claim 1, characterised by the successive method steps:
   - prefabrication of the frame (1);
   - insertion of the pane (3) into the frame (1) from the side of the angle strip (5);
   - introduction of the synthetic plastics composition in a pasty or thickly liquid condition into the space (9) between angle strip (5), frame (1) and edge (4) of the pane (3);
   - permitting the introduced synthetic plastics composition to harden into the elastic sealing strip (10).

10. Method according to claim 9, characterised in that the synthetic plastics composition is introduced under moderate pressure into the space (9).

11. Method according to claim 9 or 10, characterised in that the pane (3) is held at a short distance from the frame (1) during the introduction of the synthetic plastics composition so that a part of the synthetic plastics composition passes by way of the space (9) into the gap (15) between frame and pane.

## Revendications

1. Battant de Porte de boîtier et d'armoire pour le montage d'appareils électriques, comprenant
   - un cadre (1) qui entoure une ouverture (2);
   - une vitre transparente (3) insérée dans le cadre (1) et recouvrant l'ouverture (2);
   - une cornière (5) qui s'étend parallèlement aux bords de la vitre (3) et à distance de ceux-ci, repose avec le bord longitudinal (7) de sa branche (6) sur le cadre (1) auquel elle est rattachée, et dont l'autre branche libre (8) est orientée vers l'ouverture (2);
   - un espace (9) délimité par la cornière (5), le cadre (1) et le bord (4) e la vitre (3) et ouvert en direction de l'ouverture (2);
   - une baguette d'étanchéité élastique (10) qui remplit ledit espace (9), maintient le bord (4) de la vitre (3) et assure son étanchéité par rapport au cadre (1) et à la cornière (5);
   caractérisé en ce que
   - l'écartement entre les branches libres (8) dirigées l'une vers l'autre d'au moins deux sections de cornière (5) s'étendant le long d'arêtes opposées de la vitre (3) est légèrement plus grand que la dimension correspondante de la vitre (3);
   - la baguette d'étanchéité (10) est constituée par une masse de matière plastique élastique solidifiée introduite à l'état pâteux ou liquide qui remplit l'espace (9) entre la cornière (5), le cadre (1) et le bord (4) de la vitre (3) et applique ladite vitre (3) le long de son bord (4) uniformément contre le cadre (1).

2. Battant de porte selon la revendication 1, caractérisé en ce que la branche libre (8) s'étend au-dessus du cadre (1) à une distance qui est au moins deux fois plus grande que l'épaisseur de la vitre (3).

3. Battant de porte selon l'une des revendications 1 ou 2, caractérisé en ce que l'une des branches (6) est raccordée en arc à l'autre branche libre (8).

4. Battant de porte selon l'une des revendications 1 à 3, caractérisé en ce que le bord intérieur (11) dirigé vers l'espace (9) rempli de masse de matière plastique présente une forme arrondie entre l'une des branches (6) de la cornière (5) et le cadre (1).

5. Battant de porte selon l'une des revendications 1 à 4, caractérisé en ce qu'un joint de porte (12) est conformé en une seule pièce sur la baguette d'étanchéité (10).

6. Battant de porte selon l'une des revendications 1 à 5, caractérisé en ce que la vitre (3) est posée à plat sur le cadre (1).

7. Battant de porte selon l'une des revendications 1 à 6, caractérisé en ce que la vitre (3) est disposée à une faible distance du cadre (1) et que la masse de matière plastique remplit la fente (15) entre la vitre (3) et le cadre (1).

8. Battant de porte salon la revendication 7, caractérisé en ce que des écarteurs (14) sont insérés entre la vitre (3) et le cadre (1) et entourés latéralement de la masse de matière plastique.

9. Procédé de fabrication pour un battant de porte de boîtier et d'armoire pour le montage d'appareils électriques selon la revendication 1, **caractérisé en ce** qu'il comprend les opérations successives suivantes :
   - Préfabrication du cadre (1);
   - Mise en place de la vitre (3) dans le cadre (1) à partir du côté de la cornière (5);
   - Introduction de la masse de matière plastique à l'état pâteux ou visqueux dans l'espace (9) entre la cornière (5), le cadre (1) et le bord (4) de la vitre (3);
   - Solidification de la masse de matière plastique introduite en une baguette d'étanchéité élastique (10).

10. Procédé selon la revendication 9, caractérisé en ce que la masse de matière plastique est introduite dans l'espace (9) sous une pression modérée.

11. Procédé selon l'une des revendications 9 ou 10, caractérisé en ce que, pendant l'introduction de la masse de matière plastique, la vitre (3) est maintenue à une faible distance du cadre (1), de sorte qu'une partie de la masse de matière plastique pénètre par l'espace (9) dans la fente (15) entre le cadre et la vitre.

**Fig.1**

**Fig. 2**

Fig.3

Fig. 4